# EUROPÄISCHE PATENTSCHRIFT

(11) **EP 3 684 538 B1**
(45) Veröffentlichungstag und Bekanntmachung des Hinweises auf die Patenterteilung: **26.02.2025**
(21) Anmeldenummer: 18785826.1
(22) Anmeldetag: 22.09.2018
(51) Int. Cl.: B23K 9/10, B23K 9/32, B23K 37/00, H05K 7/20

(54) **SCHWEISSSTROMQUELLE MIT EINER KÜHLEINRICHTUNG**
WELDING POWER SUPPLY HAVING A COOLING DEVICE
SOURCE DE COURANT DE SOUDAGE AYANT UN DISPOSITIF DE REFROIDISSEMENT

(30) Priorität: 22.09.2017 DE 102017009143
(43) Veröffentlichungstag der Anmeldung: 29.07.2020
(73) Patentinhaber: SKS Welding Systems GmbH, 67661 Kaiserslautern (DE)
(72) Erfinder: KLEIN, Thomas, 67688 Rodenbach (DE)
(74) Vertreter: Klein, Friedrich Jürgen
(86) Internationale Anmeldenummer: PCT/EP2018/000445
(87) Internationale Veröffentlichungsnummer: WO 2019/057333

(56) Entgegenhaltungen:
- WO-A1-01/78932
- DE-A1- 19 926 007
- DE-B4- 19 926 007
- JP-A- 2010 099 692
- JP-A- S5 142 042
- US-A1- 2011 222 243
- US-A1- 2017 150 654

## Beschreibung

Die Erfindung betrifft eine Schweißstromquelle zur Versorgung eines elektrischen Schweißstromkreises mit elektrischem Strom und elektrischer Spannung zur Durchführung eines elektrischen Schweißverfahrens, wobei die Schweißstromquelle mit einer Stromaufbereitungseinrichtung zur Aufbereitung von der Schweißstromquelle zugeführten elektrischen Strom für eine Eignung bei einem elektrischen Schweißverfahren versehen ist, ferner an einem Gehäuse der Schweißstromquelle zwei Polkontakteinrichtungen vorgesehen sind, welche jeweils aus dem Gehäuse herausragen, und die Schweißstromquelle mit einer Kühleinrichtung versehen ist, mit welcher durch die Schweißstromquelle freigesetzte thermische Verlustwärme abführbar ist.

Es existiert eine Vielzahl von unterschiedlichen Schweißverfahren. Die vorliegende Erfindung hat besondere Bedeutung für die verschiedenen Verfahren und Schweißstromkreisvorrichtungen des Lichtbogenschweißens. Diese basieren auf einer Hitzeentwicklung eines elektrischen Lichtbogens zwischen einer Schweißelektrode und einem Werkstück, an dem eine Schweißung vorgenommen werden soll. Durch die Hitzeentwicklung kann der bzw. können die zu schweißenden Werkstoffe lokal aufgeschmolzen werden. Bei nahezu sämtlichen Lichtbogenschweißverfahren wird dem Bereich des Lichtbogens hierzu ein Schutzgas zugeführt, um einerseits eine widerstandssenkende ionisierte Atmosphäre zwischen der Schweißelektrode und dem Werkstück zu ermöglichen und um andererseits eine Oxidation der Schweißelektrode und des Werkstücks zu verhindern. Anstelle eines hierbei als Schutzgas vorgesehenen Inertgases kann auch ein Aktivgas oder eine Mischform zugeführt werden, das zur Reaktion dient. Ebenso können Elektroden vorgesehen sein, die keine externe Gaszuführung benötigen, da die hierfür erforderlichen Substanzen in den Elektroden integriert sind und beim Abschmelzen der Elektroden freigesetzt werden.

Bei Anlegen einer elektrischen Spannung an einem Schweißbrennerinnenrohr und beim Kontaktieren des Schweißdrahtes mit dem Zielmetallstück, fließt ein hoher elektrischer Strom von einem Schweißbrenner, über den Schweißdraht und gegebenenfalls einem Lichtbogen zum Zielmetallstück und dann zur Masse. Der hohe Strom und der Lichtbogen verursachen das Schmelzen des Schweißdrahtes in einer Schutzgasatmosphäre, was zur Tropfenbildung des Drahtes und zum Entstehen eines Lichtbogens führt. Dieser Lichtbogen schmilzt das Metall der Zielmetallstücke und den nachgeführten Schweißdraht. Durch Abfallen der entstandenen Tropfen des Schweißdrahtes oder durch Übergabe des Tropfens im Kurzschluss auf die verflüssigte Stelle der Zielmetallstücke, werden diese miteinander verbunden.

Lichtbogenschweißanlagen - bzw. Lichtbogenschweißstromkreise sind zur Bereitstellung des erforderlichen elektrischen Stroms und der Spannung jeweils mit einer Schweißstromquelle versehen, mit welcher der Schweißbrenner der Lichtbogenschweißanlage elektrisch leitend verbunden werden muß, damit der jeweiligen Lichtbogenschweißstelle Strom zugeführt und an sie eine Spannung angelegt werden kann. Da zur Erzeugung der an der Prozeßstelle herrschenden Bedingungen ein hoher Energiebedarf besteht, müssen Schweißstromquellen Gleichstrom oder Wechselstrom mit hohen Stromwerten (insgesamt als Schweißstrom bezeichnet) bereitstellen. Diese werden im industriellen Einsatz aus Drehstrom generiert, der an die Schweißstromquelle angeschlossen ist. Die Schweißstromquellen transformieren mittels in der Schweißstromquelle enthaltenen Induktivitäten und Leistungselektronik den eingangsseitig anstehenden Drehstrom zu Schweißstrom um, wie er zum Lichtbogenschweißen geeignet ist. Hierbei entsteht typischerweise eine hohe thermische Verlustwärme, die zur Vermeidung von Beschädigungen insbesondere der in der Schweißstromquelle enthaltenen Elektronik, aus dem Gehäuse abgeführt werden muß. Hierzu ist typischerweise in der Schweißstromquelle eine Kühleinrichtung angeordnet, durch die jedoch das Gehäuse der Schweißstromquelle vergleichsweise groß ausfällt. Beispiele hierfür sind in der JP S51-42042 A sowie der JP 2010 099692 A beschrieben.

Schließlich ist aus der DE 199 26 007 A1 eine Schweißstromquelle vorbekannt, die zur Kühlung an einer Gehäuseaußenseite einen Kühlkörper aufweist, in dessen Bereich ein Ventilator angeordnet ist.

Die WO 01/78932 A1 beschreibt eine Schweißstromquelle mit einer Induktion, welche in einem im wesentlichen kubischen Gehäuse angeordnet ist und mit einem Deckel des Gehäuses verschlossen werden kann. Die Induktion befindet sich im Inneren des Gehäuses in einer wärmeleitenden Flüssigkeit. An Außenseiten des Gehäuses sind Kühlrippen vorgesehen, über die von der Kühlflüssigkeit an das Gehäuse abgegebene Wärme abgeführt werden soll.

In der US 2011/0222243 ist eine Schweißstromquelle beschrieben, die ein im wesentlichen geschlossenes Gehäuse aufweist. Das Gehäuse ist durch Trennwände in mehrere Kammern unterteilt. In einer der Kammern befinden sich an einer Seite einer Trennwand Wärme erzeugende elektronische Komponenten. Auf der anderen Seite der Trennwand sind Kühlrippen angeordnet, an welchen durch einen Ventilator bewegte Luft vorbeiströmt, um dadurch Wärme von den Kühlrippen aufzunehmen und aus Öffnungen des Gehäuses abzuführen.

Die US 2017/0150654 A1 betrifft einen Leistungswandler für Industriemaschinen. Diese Schrift offenbart einen Leistungswandler mit einem Gehäuse, das einen ersten Raum S1 und einen zweiten Raum aufweist. Der erste Raum und der zweite Raum sind durch eine Trennwand voneinander getrennt. Im ersten Raum S1 befindet sich eine Schaltungsanordnung zur Leistungswandlung. Die Schaltungsanordnung liegt im ersten Raum an der Trennwand an. Im zweiten Raum ist ein Kanal für Kühlflüssigkeit angeordnet, mit welcher die Schaltungsanordnung im ersten Raum gekühlt wird. An einer Gehäuseinnenseite des zweiten Raums sind Kühlrippen zur Abfuhr der von der Schaltungsanordnung kommenden Wärme angeordnet. Zudem ragen Elektrokondensatoren aus dem ersten Raum in den zweiten Raum, welcher an seiner Rückseite offen ist.

Der Erfindung liegt deshalb die Aufgabe zugrunde eine Schweißstromquelle der eingangs genannten Art bereit zu stellen, bei der trotz einer ausreichenden Kühlung der elektrischen Komponenten die Möglichkeit gegeben ist, das Gehäuse der Schweißstromquelle kleiner als bisher zu gestalten.

Diese Aufgabe wird bei einer Schweißstromquelle der eingangs genannten Art erfindungsgemäß dadurch gelöst, daß eine Induktivitätseinrichtung der Stromtransformationseinrichtung in einem Kühlkörper angeordnet ist und der Kühlkörper zusammen mit der Induktivitätseinrichtung auf einer Gehäuseaußenseite des Gehäuses angeordnet ist. Es hat sich im Rahmen der Erfindung überraschenderweise gezeigt, daß mit der Verlagerung der Kühleinrichtung und der Induktivitätseinrichtung aus dem Innenraum des Gehäuses heraus an eine Außenseite des Gehäuses, das Gehäuse stärker verkleinert werden kann, als nur um das Volumen der Kühleinrichtung und der Induktivitätseinrichtung. Bei innerhalb des Gehäuseraums angeordneten Kühlkörper und Induktivitätseinrichtung muß nämlich in der Regel zur Vermeidung einer zu starken Erwärmung ein Mindestabstand zwischen ebenfalls im Gehäuse angeordneten Elektronikkomponenten und der Induktivitätseinrichtung, wie beispielsweise dem Transformator eingehalten werden. Außerdem wird im Gehäuse Befestigungsmaterial zur Befestigung der Induktivitätseinrichtung und der Kühleinrichtung benötigt, was ebenfalls zur Vergrößerung des Innenraums des Gehäuses beiträgt. Durch Wegfall all dieser Komponenten und der für die erforderlichen Verkabelungen im Gehäuse und auch durch Wegfall des Erfordernisses einen Mindestabstand zur Induktivitätseinrichtung einhalten zu müssen, kann das Gehäuse somit deutlich kleiner ausfallen, als es sich nur durch die Volumenreduzierung um die erfindungsgemäß nicht mehr innerhalb des Gehäuses vorgesehenen Komponenten ergeben würde. Durch die erfindungsgemäße Maßnahme ergibt sich zudem der Vorteil, daß die Verlustwärme besonders schnell und wirksam an die Umgebung abgegeben werden kann, da die Gefahr eines Wärmestaus oder einer erschwerten Ableitung der Warmluft aus dem Gehäuse heraus, nicht gegeben ist.

Es kann vorgesehen sein, daß die Induktivitätseinrichtung mit zumindest einem Transformator versehen ist, der innerhalb des Kühlkörpers angeordnet ist. Mit einer solchen Ausführungsform der Erfindung können der Kühlkörper und die Induktivitätseinrichtung besonders platzsparend angeordnet und gleichzeitig besonders wirksam die durch die Induktivitätseinrichtung anfallende thermische Verlustwärme an die Umgebung abgeführt werden.

Trotz der Anordnung der Induktivitätseinrichtung außerhalb des Gehäuses der Schweißstromquelle, lässt sich die Induktivitätseinrichtung sicher dadurch vor Beschädigungen schützen, daß über der Induktivitätseinrichtung eine Abdeckung, insbesondere ein Strömungsleitblech, angeordnet ist. Um trotz der Abdeckung eine gute Wärmeableitung zu erreichen, kann in zweckmäßiger Weise vorgesehen sein, daß in einer vorgesehenen Gebrauchslage der Schweißstromquelle die Abdeckung in einem Bereich mit ihrem größten Abstand zu einer vorgesehenen Aufstellfläche der Schweißstromquelle und zur Induktivitätseinrichtung beabstandet angeordnet ist, so daß sich eine Öffnung zwischen der Abdeckung und der Induktivitätseinrichtung ergibt, aus welcher Warmluft abströmen kann.

In einer bevorzugten Ausführungsform der Erfindung kann ferner vorgesehen sein, daß der Kühlkörper auf einer Außenseite einer Gehäuserückwand angeordnet ist. Die Rückseite des Gehäuses eignet sich in besonderem Maße zur Anordnung des Kühlkörpers und der Induktivitätseinrichtung, da hier durch Ausnehmungen in der Rückwand auf besonders kurzem Weg eine Verkabelung der Induktivitätseinrichtung mit im Gehäuse angeordneten Elektronikkomponenten erreicht werden kann.

Ein besonders guter und schneller Wärmeabtransport läßt sich in einer bevorzugten Ausführungsform der Erfindung dadurch erreichen, daß mit Abstand zueinander angeordnete Kühlrippen des Kühlkörpers zumindest im wesentlichen senkrecht verlaufen. Hierdurch läßt sich in besonders günstiger Weise die sich von selbst ergebende Konvektion zum Wärmeabtransport nutzen. Erwärmte Luft kann somit im Bereich des Kühlkörpers zwischen den Kühlrippen ungehindert aufsteigen und somit im wesentlichen in senkrechter Richtung strömen.

Des Weiteren ist der außerhalb des Gehäuses angeordnete Kühlkörper im Bereich seiner Kühlrippen vorzugsweise mit einer Ausnehmung versehen, durch welche mehrere Kühlrippen unterbrochen sind, wobei die Ausnehmung zur Anordnung der Induktivitätseinrichtung im Kühlkörper vorgesehen ist. Die Induktivitätseinrichtung kann somit vorzugsweise von einer dem Gehäuse abgewandten Seite in die Ausnehmung der Kühleinrichtung eingesetzt sein.

Um den Wärmeabtransport und damit die Kühlwirkung nochmals zu steigern, kann vorzugsweise vorgesehen sein, daß insbesondere auf der, dem Gehäuse abgewandten Seite der Induktivitätseinrichtung, eine Lüftereinrichtung angeordnet ist. Diese somit ebenfalls außerhalb des Gehäuses der Schweißstromquelle angeordnete Lüftereinrichtung kann insbesondere als eine eigenständige Baugruppe, eine sogenannte Lüfterkassette, ausgebildet und mit zumindest einem rotierenden Lüfter versehen sein, dessen Luftstrom im wesentlichen auf die Induktivitätseinrichtung gerichtet ist. In besonders vorteilhafter Weise kann die Lüfterkassette möglichst offen gestaltet sein, so daß der die Wärme der Induktionseinrichtung abtransportierende Luftstrom möglichst ungehindert strömen kann. Die Lüfterkassette sollte somit vorzugsweise nicht die gesamte Rückseite des Kühlkörpers, sondern vorzugsweise im wesentlichen nur den Bereich der Induktivitätseinrichtung abdecken. Ausserdem sollte ebenfalls mit Vorteil die Oberseite des Kühlkörpers derart gestaltet sein, daß hier die abströmende Luft möglichst ungehindert aus dem Kühlkörper austreten kann. An der Oberseite des Kühlkörpers sollte dieser somit in einer besonders günstigen Ausführungsform der Erfindung möglichst frei von einer Abdeckung sein.

Schließlich kann in einer sich als vorteilhaft erwiesenen Weiterbildung der Erfindung vorgesehen sein, daß die Schweißstromquelle mit zwei oder mehr auf einer Außenseite des Gehäuses der Schweißstromquelle aufgesetzten Kühlkörpern versehen ist, wobei jeder dieser Kühlkörper zumindest eine Induktivitätseinrichtung aufweist und in einer der zuvor beschriebenen Weisen ausgebildet sein kann.

Weitere bevorzugte Ausgestaltungen der Erfindung ergeben sich aus den Ansprüchen, der Beschreibung und der Zeichnung.

Die Erfindung wird anhand von in den Figuren rein schematisch dargestellten Ausführungsbeispielen näher erläutert, es zeigen:
- Fig. 1: eine perspektivische Darstellung einer erfindungsgemäßen Schweißstromquelle für Lichtbogenschweißverfahren mit an deren zwei Polkontakteinrichtungen angeschlossenen Schweißstromkabeln;
- Fig. 2: eine perspektivische Darstellung der Schweißstromquelle aus Fig. 1 mit Blickrichtung auf eine Rückseite und mit entfernter Lüfterkassette;

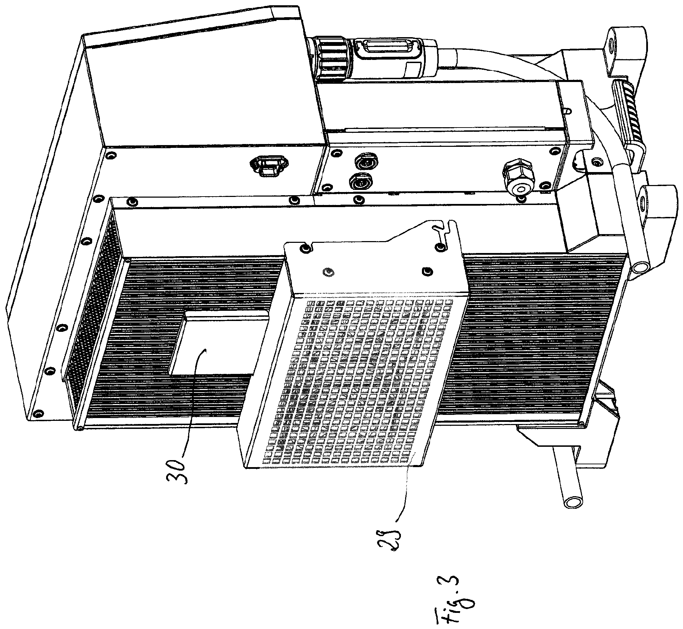

- Fig. 3: eine weitere perspektivische Darstellung der Schweißstromquelle aus Fig. 1 mit montierter Lüfterkassette mit Blickrichtung auf die Rückseite;

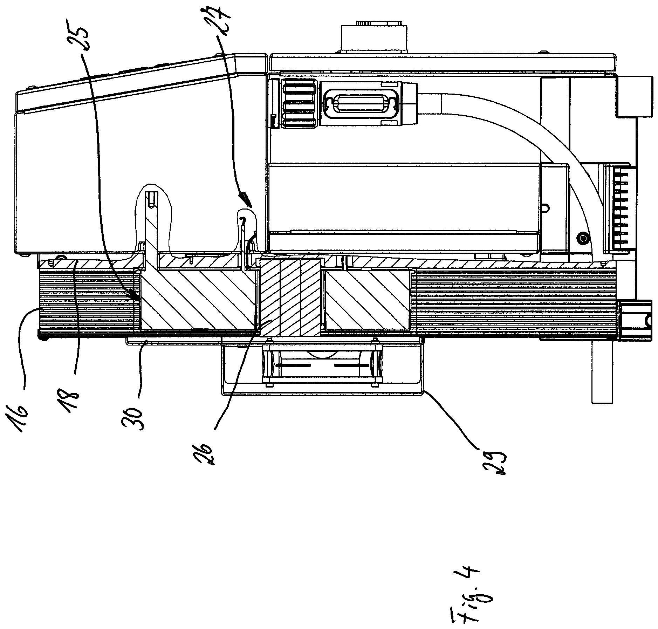

- Fig. 4: eine Seitenansicht der Schweißstromquelle aus Fig. 1 mit einer geschnitten dargestellten Lüfterkassette und Induktivitätseinrichtung;
- Fig. 5: eine Explosionsdarstellung der Schweißstromquelle aus Fig. 1

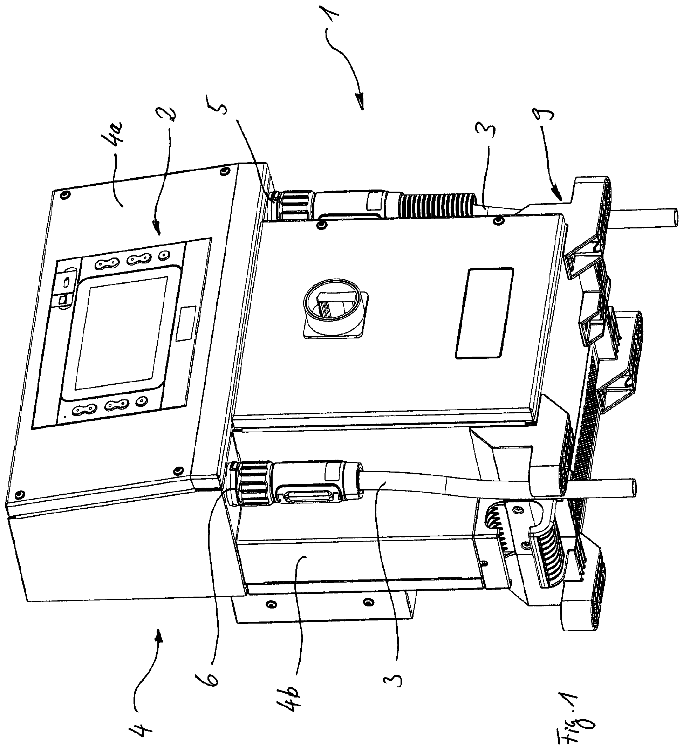

In Fig. 1 ist eine Schweißstromquelle 1 gezeigt, mit der elektrischer Strom und eine elektrische Spannung für die Durchführung von Lichtbogenschweißverfahren mittels eines nicht näher dargestellten Lichtbogenschweißbrenners zur Verfügung gestellt werden. Außerdem enthält die Schweißstromquelle 1 eine Steuerungseinrichtung mit einem Bedienpanel 2, mit welchem Parameter des jeweils durchzuführenden Lichtbogenschweißverfahrens eingestellt und der Schweißprozeß gesteuert werden kann. Vorliegend können mit der Schweißstromquelle 1 beispielsweise MIG/MAG oder auch WIG-, Plasma-, Elektroden- sowie sämtliche weiteren Lichtbogenschweißverfahren oder Hochstromanwendungen ausgeführt werden. In weiteren möglichen Ausführungsformen der Erfindung können mit der Schweißstromquelle 1 auch andere Lichtbogenschweiß- und -trennverfahren ausgeführt werden.

Aus einem Gehäuse 4 der Schweißstromquelle 1 ragen zwei Polkontakteinrichtungen 5, 6 heraus, die zum Anschluß von jeweils einem Schweißstromkabel 3 vorgesehen sind. Wie in Fig. 1 zu erkennen ist, steht der obere Abschnitt 4a des Gehäuses 4 an beiden Seiten des Gehäuses in Bezug auf den schmalen vorderen Teils 130 der T-Form des unteren Gehäuseabschnitts 4b über. Hinsichtlich des hinteren, breiteren Teils 131 der T-Form des unteren Gehäuseabschnitts 4b, weist der obere Gehäuseabschnitt 4a eine Breite auf, die zumindest in etwa der Breite des hinteren, breiteren Teils 131 des unteren Gehäuseabschnitts 4b entspricht. Durch diese Ausgestaltung ergibt sich an den Seiten des Gehäuses 4 jeweils ein Bereich des oberen Gehäuseabschnitts 4a, bei dem eine Unterseite 7 des überstehenden Teils des oberen Gehäuseabschnitts 4a durch eine Gehäuseabdeckung, hier ein Gehäuseblech, abgedeckt und diese frei zugänglich ist. Diese beiden Bereiche der Unterseite 7 des oberen Gehäuseabschnitts 4a sind im Ausführungsbeispiel rechteckförmig und von der Vorderseite sowie von jeweils einer Seite des Gehäuses 4 für einen Zugriff frei zugänglich. Diese beiden Bereiche der Unterseite 7 des oberen Gehäuseabschnitts 4a sind durch den schmalen Teil der T-Form des unteren Gehäuseabschnitts voneinander getrennt. An jeder der beiden Bereiche der Unterseite 7 des oberen Gehäuseabschnitts 4a ist jeweils eine der beiden Polkontakteinrichtungen 5, 6 angeordnet, so daß sich an jedem dieser beiden Bereiche jeweils nur eine der Polkontakteinrichtungen 5, 6 befindet. Die beiden Polkontakteinrichtungen 5, 6 ragen somit an der Unterseite 7 des oberen Gehäuseabschnitts 4a aus dem Gehäuse 4 der bevorzugten erfindungsgemäßen Schweißstromquelle 1 heraus. Das Gehäuse 4 der Schweißstromquelle ist an einem zweiteiligen Aufstellelement 9 angeordnet, mit welcher das Gehäuse auf einem Untergrund aufgestellt werden kann.

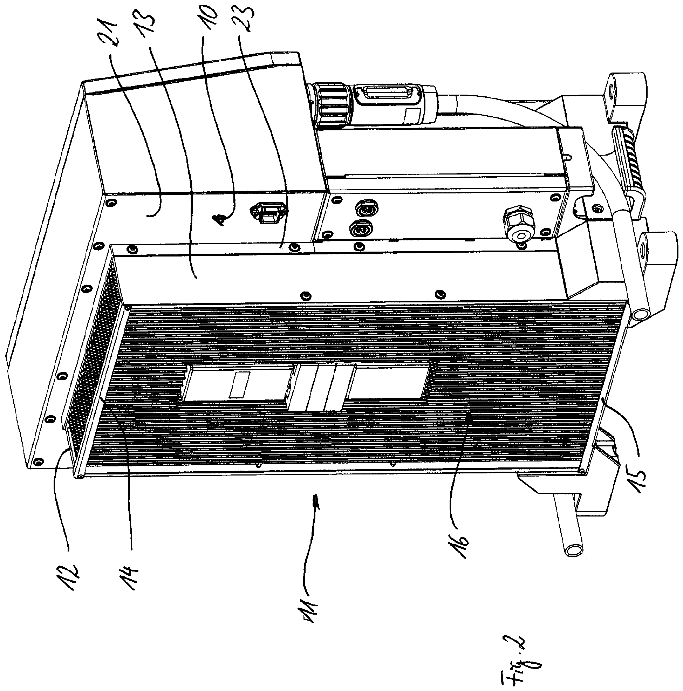

Wie aus Fig. 2 hervorgeht, befindet sich auf der Rückseite 10 des Gehäuses 4 ein kasten- und quaderförmiger Kühlkörper 11. Der Kühlkörper 11 erstreckt sich im wesentlichen über die gesamte Höhe des Gehäuses 4 und weist zwei zumindest im wesentlichen senkrechte Seitenwände 12, 13 auf, die mittels Querstreben 14, 15 miteinander verbunden sind. Zwischen den Seitenwänden sind eine Vielzahl von Kühlrippen 16 angeordnet. Die Kühlrippen 16 sind parallel zu den Seitenwänden 12, 13 und damit ebenfalls zumindest im wesentlichen senkrecht zur Gehäuserückwand 21 und zudem vertikal ausgerichtet. Die Ausrichtung der Kühlrippen entspricht der sich von selbst einstellenden Wärmekonvektion bzw. Strömungsrichtung von erwärmter Luft. Die Länge der im wesentlichen gleich langen Kühlrippen 16 entspricht dabei im wesentlichen der Länge der Seitenwände 12, 13. Mittels einer Rückwand 18 ist der Kühlkörper 11 zur Gehäuserückwand 21 des Gehäuses hin geschlossen.

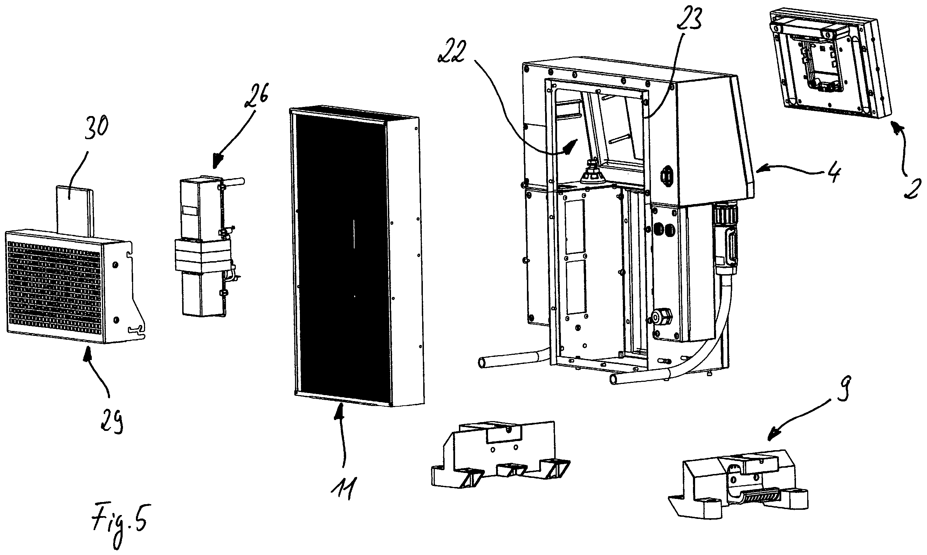

Der Explosionsdarstellung von Fig. 5 kann entnommen werden, daß die Rückseite 10 des Gehäuses 4 der Schweißstromquelle 1 mit einer Gehäuserückwand 21 versehen ist, die mit einer rechteckförmgen Ausnehmung 22 versehen ist. Die Form und Größe der Ausnehmung 22 entspricht dabei im wesentlichen der Form des Kühlkörpers 11. Beispielsweise mittels eines Rahmens 23 und Schraubverbindungen kann der Kühlkörper 11 an der Rückwand 21 des Gehäuses 4 befestigt werden. Mit der in Fig. 6 gezeigten Rückwand 18 des Kühlkörpers 11 kann die Ausnehmung 22 der Gehäuserückwand 21 vollständig verschlossen werden.

Etwa mittig im Kühlkörper sind die in diesem Bereich angeordneten Aluminiumkühlrippen 16 mit einer länglichen rechteckförmigen Ausnehmung 25 versehen, die beispielsweise durch eine Ausfräsung erzielt werden kann. In der Ausnehmung 25 ist eine Induktivitätseinrichtung 26 angeordnet, die etwa der länglichen Quaderform der Ausnehmung 25 entspricht. Die Induktivitätseinrichtung 26 enthält zumindest einen Transformator und gegebenenfalls eine oder mehrere weitere Induktivitäten. Der zumindest eine Transformator ist zur besseren Wärmeabfuhr von einer Kunststoffmasse umgossen. Der sich daraus ergebende quaderförmige Block der Induktivitätseinrichtung 26 ist in die Ausnehmung 25 der Kühlrippen eingesetzt und an der Rückwand 18 befestigt. Elektrische Anschlüße 27 der Induktivitätseinrichtung 26 sind durch ein oder mehrere Durchgangsausnehmungen durch die Rückwand 18 geführt, um mit nicht näher dargestellten Elektronikkomponenten innerhalb des Gehäuses elektrisch verbunden zu sein. Dabei deckt die Induktivitätseinrichtung sämtliche hierfür vorgesehene Durchgangsausnehmungen der Rückwand 18 ab. Auf der Gehäuseinnenseite können an der Rückwand 18 wärmeabgebende Elektronikkomponenten angeordnet sein.

Deren thermische Verlustenergie kann somit direkt über die Rückwand 18 den auf der Außenseite des Gehäuses angeordneten Kühlrippen zugeführt und an die Umgebung abgeführt werden.

Bei der dargestellten bevorzugten erfindungsgemäßen Ausführungsform kann optional eine als Lüfterkassette 29 ausgebildete Lüftereinrichtung über der Induktivitätseinrichtung angeordnet sein. Die Lüftereinrichtung kann mit einem oder mehreren elektrisch angetriebenen Lüfter versehen sein, wobei der von dem zumindest einen Lüfter der Lüfterkassette 29 erzeugte Luftstrom im wesentlichen senkrecht auf die Induktivitätseinrichtung 26 und die in diesem Bereich angeordneten Kühlrippen gerichtet ist. Die Lüfterkassette 29 überdeckt nur einen Teil der Kühlrippen. An der Lüftereinrichtung bzw. -kassette 29 kann eine als Schutz- und Leitblech fungierende Abdeckung 30 angeordnet sein, mit der ein über die Lüftereinrichichtung hinausragender Abschnitt der Induktivitätseinrichtung 26 überdeckt sein kann. Insbesondere an seinem oberen Ende kann die Abdeckung 30 mit Abstand zur Induktivitätseinrichtung angeordnet sein, während sie an ihren beiden Seiten in Richtung auf die Induktivitätseinrichtung umgebogen ist. Die Abdeckung 30 kann somit auch die Funktion innehaben, einen nach oben gerichteten Strömungskanal zu bilden, mittels dem durch die Induktivitätseinrichtung erwärmte Luft nach oben abströmen kann.

### Bezugszeichenliste

| | | | |
|---|---|---|---|
| 1 | Schweißstromquelle | 21 | Gehäuserückwand |
| 2 | Bedienpanel | 22 | Ausnehmung |
| 3 | Schweißstromkabel | 23 | Rahmen |
| 4 | Gehäuse | 25 | Ausnehmung |
| 4a | oberer Gehäuseabschnitt | 26 | Induktivitätseinrichtung |
| 4b | unterer Gehäuseabschnitt | 27 | elektrische Anschlüsse |
| 5 | Polkontakteinrichtung | 29 | Lüfterkassette |
| 6 | Polkontakteinrichtung | 30 | Abdeckung |
| 7 | Unterseite | | |
| 9 | Aufstellelement | | |
| 10 | Rückseite | | |
| 11 | Kühlkörper | | |
| 12 | Seitenwand | | |
| 13 | Seitenwand | | |
| 14 | Querstrebe | | |
| 15 | Querstrebe | | |
| 16 | Kühlrippen | | |
| 18 | Rückwand Kühlkörper | | |

## Patentansprüche

1. Schweißstromquelle (1) zur Versorgung eines elektrischen Schweißstromkreises mit elektrischem Strom und elektrischer Spannung zur Durchführung eines elektrischen Schweißverfahrens, wobei die Schweißstromquelle (1) mit einer Stromtransformationseinrichtung zur Aufbereitung von der Schweißstromquelle (1) zugeführten elektrischen Strom für eine Eignung bei einem elektrischen Schweißverfahren versehen ist, ferner an einem Gehäuse (4) der Schweißstromquelle (1) zwei Polkontakteinrichtungen (5, 6) vorgesehen sind, welche jeweils aus dem Gehäuse (4) herausragen, und die Schweißstromquelle (1) mit einer Kühleinrichtung versehen ist, mit welcher durch die Schweißstromquelle (1) freigesetzte thermische Verlustwärme abführbar ist,
**dadurch gekennzeichnet, daß**
eine zumindest einen Transformator oder eine sonstige Induktivität aufweisende Induktivitätseinrichtung (26) der Stromtransformationseinrichtung in einem Kühlkörper (11) der Kühleinrichtung angeordnet und der Kühlkörper (11) zusammen mit der Induktivitätseinrichtung (26) auf einer Gehäuseaußenseite des Gehäuses (4) der Schweißstromquelle (1) angeordnet ist.

2. Schweißstromquelle nach Anspruch 1, **dadurch gekennzeichnet, daß** die Kühleinrichtung an einer Außenseite einer Gehäuserückwand (21) angeordnet ist.

3. Schweißstromquelle nach einem der beiden vorhergehenden Ansprüche, **dadurch gekennzeichnet, daß** an der der Gehäuseaußenseite abgewandten Seite der Kühleinrichtung auf der Kühleinrichtung eine Lüftereinrichtung angeordnet ist.

4. Schweißstromquelle nach einem der vorhergehenden Ansprüche, **dadurch gekennzeichnet, daß** die Induktivitätseinrichtung (26) mit zumindest einem Transformator und zumindest einer weiteren Induktivität versehen ist, die innerhalb eines Kühlkörpers (11) der Kühleinrichtung angeordnet ist.

5. Schweißstromquelle nach einem der vorhergehenden Ansprüche, **dadurch gekennzeichnet, daß** die Kühleinrichtung mit Kühlrippen (16) versehen ist, vorzugsweise mit zumindest im wesentlichen senkrecht ausgerichteten und mit Abstand zueinander angeordneten Kühlrippen (16).

6. Schweißstromquelle nach einem der vorhergehenden Ansprüche, **dadurch gekennzeichnet, daß** über der Induktivitätseinrichtung eine Abdeckung (30), insbesondere ein Strömungsleitblech, angeordnet ist, das.

7. Schweißstromquelle nach einem der vorhergehenden Ansprüche, **dadurch gekennzeichnet, daß** die zumindest eine Induktivität, insbesondere ein Transformator, in eine Kunststoffmasse eingegossen ist.

8. Schweißstromquelle nach einem der vorhergehenden Ansprüche, **dadurch gekennzeichnet, daß** die Kühleinrichtung mit einer Rückwand versehen ist, mit welcher eine Ausnehmung einer Gehäuserückwand (21) verschlossen ist.

9. Schweißstromquelle nach Anspruch 8, **dadurch gekennzeichnet, daß** an einer Gehäuseinnenseite der Rückwand Elektronikkomponenten der Schweißstromquelle (1) angeordnet sind.

10. Schweißstromquelle nach Anspruch 8 oder 9, **gekennzeichnet durch** zumindest eine Ausnehmung (22) der Rückwand (21), durch die zumindest ein elektrischer Anschluß der Induktivitätseinrichtung (26) in das Gehäuse (4) der Schweißstromquelle (1) geführt ist.

11. Schweißstromquelle nach einem der vorhergehenden Ansprüche, gekennzeichet durch mehrere auf einer oder mehreren Gehäußeaußenseiten der Schweißstromquelle (1) angeordneten Kühlkörpern (11), wobei jeder der Kühlkörper (11) mit jeweils einer Induktivitätseinrichtung (26) versehen ist, und die jeweilige Induktivitätseinrichtung (26) zumindest einen Transformator aufweist.

## Claims

1. Welding power source (1) for supplying an electric welding circuit with electric current and electric voltage for carrying out an electric welding process, the welding power source (1) being provided with a current transformation device for conditioning electric current supplied to the welding power source (1) for suitability in an electric welding process, furthermore, two pole contact devices (5, 6) are provided on a housing (4) of the welding power source (1), which pole contact devices each protrude from the housing (4), and the welding power source (1) is provided with a cooling device by means of which thermal heat loss released by the welding power source (1) can be dissipated,
**characterized in that**
an inductance device (26) of the current transformation device having at least one transformer or another inductance is arranged in a heat sink (11) of the cooling device and the heat sink (11) is arranged together with the inductance device (26) on an outer side of the housing (4) of the welding current source (1).

2. Welding power source according to claim 1, **characterized in that** the cooling device is arranged on an outer side of a rear wall (21) of the housing.

3. Welding power source according to one of the two preceding claims, **characterized in that** a fan device is arranged on the cooling device on the side of the cooling device facing away from the outside of the housing.

4. Welding power source according to one of the preceding claims, **characterized in that** the inductance device (26) is provided with at least one transformer and at least one further inductance which is arranged inside a heat sink (11) of the cooling device.

5. Welding power source according to one of the preceding claims, **characterized in that** the cooling device is provided with cooling fins (16), preferably with at least substantially vertically aligned cooling fins (16) arranged at a distance from one another

6. Welding current source according to one of the preceding claims, **characterized in that** a cover (30), in particular a flow guide plate, is arranged above the inductance device, which.

7. Welding current source according to one of the preceding claims, **characterized in that** the at least one inductance, in particular a transformer, is cast into a plastic mass.

8. Welding power source according to one of the preceding claims, **characterized in that** the cooling device is provided with a rear wall with which a recess of a rear wall (21) of a housing is closed.

9. Welding power source according to claim 8, **characterized in that** electronic components of the welding power source (1) are arranged on an inner side of the rear wall of the housing.

10. Welding power source according to claim 8 or 9, **characterized by** at least one recess (22) of the rear wall (21), through which at least one electrical connection of the inductance device (26) is led into the housing (4) of the welding power source (1).

11. Welding power source according to one of the preceding claims, **characterized by** a plurality of heat sinks (11) arranged on one or more outer sides of the housing of the welding power source (1), each of the heat sinks (11) being provided with a respective inductance device (26), and the respective inductance device (26) having at least one transformer

## Revendications

1. Source de courant de soudage (1) pour l'alimentation d'un circuit électrique de soudage en courant électrique et en tension électrique pour la mise en oeuvre d'un procédé de soudage électrique, la source de courant de soudage (1) étant pourvue d'un dispositif de transformation de courant pour la préparation du courant électrique amené à la source de courant de soudage (1) pour une aptitude dans un procédé de soudage électrique, en outre, deux dispositifs de contact polaire (5, 6) sont prévus sur un boîtier (4) de la source de courant de soudage (1), lesquels font respectivement saillie hors du boîtier (4), et la source de courant de soudage (1) est pourvue d'un dispositif de refroidissement avec lequel la chaleur de perte thermique libérée par la source de courant de soudage (1) peut être évacuée,
**caractérisé en ce que**
un dispositif d'inductance (26), présentant au moins un transformateur ou une autre inductance, du dispositif de transformation du courant est disposé dans un corps de refroidissement (11) du dispositif de refroidissement et le corps de refroidissement (11) est disposé, conjointement avec le dispositif d'inductance (26), sur un côté extérieur du boîtier (4) de la source de courant de soudage (1).

2. Source de courant de soudage selon la revendication 1, **caractérisée en ce que** le dispositif de refroidissement est disposé sur un côté extérieur d'une paroi arrière (21) du boîtier.

3. Source de courant de soudage selon l'une des deux revendications précédentes, **caractérisée en ce qu'**un dispositif de ventilation est disposé sur le dispositif de refroidissement, sur le côté du dispositif de refroidissement qui est opposé au côté extérieur du boîtier.

4. Source de courant de soudage selon l'une des revendications précédentes, **caractérisée en ce que** le dispositif d'inductance (26) est pourvu d'au moins un transformateur et d'au moins une autre inductance qui est disposée à l'intérieur d'un corps de refroidissement (11) du dispositif de refroidissement.

5. Source de courant de soudage selon l'une des revendications précédentes, **caractérisée en ce que** le dispositif de refroidissement est pourvu d'ailettes de refroidissement (16), de préférence d'ailettes de refroidissement (16) orientées au moins essentiellement verticalement et disposées à distance les unes des autres

6. Source de courant de soudage selon l'une des revendications précédentes, **caractérisée en ce qu'**un couvercle (30), en particulier une tôle de guidage d'écoulement, est disposé au-dessus du dispositif d'inductance, qui.

7. Source de courant de soudage selon l'une des revendications précédentes, **caractérisée en ce que** la au moins une inductance, en particulier un transformateur, est coulée dans une masse de matière plastique.

8. Source de courant de soudage selon l'une des revendications précédentes, **caractérisée en ce que** le dispositif de refroidissement est pourvu d'une paroi arrière avec laquelle un évidement d'une paroi arrière (21) du boîtier est fermé.

9. Source de courant de soudage selon la revendication 8, **caractérisée en ce que** des composants électroniques de la source de courant de soudage (1) sont disposés sur un côté intérieur du boîtier de la paroi arrière.

10. Source de courant de soudage selon la revendication 8 ou 9, **caractérisée par** au moins un évidement (22) de la paroi arrière (21), à travers lequel au moins un raccordement électrique du dispositif d'inductance (26) est guidé dans le boîtier (4) de la source de courant de soudage (1).

11. Source de courant de soudage selon l'une des revendications précédentes, **caractérisée par** plusieurs corps de refroidissement (11) disposés sur une ou plusieurs faces extérieures du boîtier de la source de courant de soudage (1), chacun des corps de refroidissement (11) étant pourvu d'un dispositif d'inductance (26) respectif, et le dispositif d'inductance (26) respectif présentant au moins un transformateur
